**Europäisches Patentamt**

**European Patent Office**

**Office européen des brevets**

(19)

(11) Veröffentlichungsnummer: **0 033 467**

**A2**

(12) # EUROPÄISCHE PATENTANMELDUNG

(21) Anmeldenummer: **81100390.4**

(22) Anmeldetag: **20.01.81**

(51) Int. Cl.³: **H 05 K 3/00**
**H 05 K 3/38, B 32 B 31/12**

(30) Priorität: **30.01.80 DE 3003303**

(43) Veröffentlichungstag der Anmeldung:
**12.08.81 Patentblatt 81/32**

(84) Benannte Vertragsstaaten:
**BE FR GB IT NL SE**

(71) Anmelder: **SIEMENS AKTIENGESELLSCHAFT Berlin
und München
Postfach 22 02 61
D-8000 München 22(DE)**

(72) Erfinder: **Merkenschlager, Hans-Hermann, Dipl.-Ing.
Spielfeld-Strasse 15
D-8900 Augsburg(DE)**

(72) Erfinder: **Müller, Georg, Ing. grad.
Blütenstrasse 1
D-8901 Rettenbergen(DE)**

(72) Erfinder: **Roith, Edgar, Ing. grad.
Landsberger Strasse 23
D-8901 Königsbrunn(DE)**

(54) **Verfahren zur Mattierung von hochglänzenden Epoxidharzoberflächen bei Leiterplatten.**

(57) Die Erfindung bezieht sich auf ein Verfahren zur Mattierung von hochglänzenden Epoxidharzoberflächen, insbesondere bei Leiterplatten. In der neueren Leiterplattentechnologie werden Leiterplatten mit modifizierten Epoxidharzlacken als Lötstoppabdeckung und als Schutzabdeckung beschichtet. Diese Beschichtungen sind mechanisch sehr stabil, ergeben aber stark glänzende reflektierende Oberflächen. Diese lichtreflektierende Oberfläche stört jedoch bei der Beschichtung derartiger Leiterplatten. Die Erfindung sieht hierzu ein Verfahren vor, bei dem die Leiterplatten über ein Spritzmodul geführt werden, das die Leiterplatte beidseitig mit technisch reiner Schwefelsäure besprüht. Das erfindungsgemäße Verfahren eignet sich allgemein zur Mattierung hochglänzender Epoxidharzoberflächen.

EP 0 033 467 A2

0033467

SIEMENS AKTIENGESELLSCHAFT          Unser Zeichen
Berlin und München                  VPA 80 P 2009 E

Verfahren zur Mattierung von hochglänzenden Epoxidharzoberflächen bei Leiterplatten

---

Die Erfindung betrifft ein Verfahren zur Mattierung von
hochglänzenden Epoxidharzoberflächen, insbesondere bei
Leiterplatten.

In der neureren Leiterplattentechnologie werden Leiterplatten mit modifizierten Epoxidharzlacken als Lötstoppabdeckung und als Schutzabdeckung beschichtet. Diese
Beschichtungen sind mechanisch sehr stabil, ergeben aber
stark glänzende reflektierende Oberflächen. Diese lichtreflektierende Oberfläche stört jedoch bei der Beschichtung derartiger Leiterplatten.

Aufgabe der vorliegenden Erfindung ist es, ein einfaches
Verfahren zur Mattierung glänzender Epoxidharzoberflächen bei Leiterplatten anzugeben.

Zur Lösung dieser Aufgabe wird gemäß der Erfindung derart verfahren, daß die Leiterplatten über ein Spritzmodul
geführt werden, das die Leiterplatte beidseitig mit technisch reiner Schwefelsäure besprüht.

Dabei ist es vorteilhaft, daß die Leiterplatten mit
einer maximalen Geschwindigkeit von 10 m/min
an dem Spritzmodul vorbeigeführt wird. Die Schwefelsäure liegt dabei in einem Konzentratbereich von 90 %
bis 96%.

Zk 1 Stl / 22.1.80

0033467

- 2 -    VPA 80 P 2 0 0 9 E

Durch dieses Verfahren wird in einfacher Weise eine Mattierung erreicht, durch die einerseits ein leichteres Bearbeiten derartiger Leiterplatten bei der Bestückung ermöglicht wird, das aber andererseits auch eine schonende Behandlung der Epoxidharzoberflächen gewährleistet.

3 Patentansprüche

Patentansprüche

1. Verfahren zur Mattierung von hochglänzenden Epoxidharzoberflächen, insbesondere bei Leiterplatten, d a durch gekennzeichnet , daß die Leiterplatten über ein Spritzmodul geführt werden, das die Leiterplatte beidseitig mit technisch reiner Schwefelsäure besprüht.

2. Verfahren nach Anspruch 1, d a d u r c h g e kennzeichnet , daß die Leiterplatten mit einer maximalen Geschwindigkeit von 10 m/min an dem Spritzmodul vorbeigeführt werden.

3. Verfahren nach einem der vorhergehenden Ansprüche, dadurch gekennzeichnet , daß die Schwefelsäure im Konzentratsbereich von 90% bis 96 % liegt.